# EUROPEAN PATENT SPECIFICATION

(11) **EP 2 241 390 B1**
(45) Date of publication and mention of the grant of the patent: **08.08.2012**
(21) Application number: 09158051.4
(22) Date of filing: 16.04.2009
(51) Int. Cl.: B21D 53/04, B21J 15/00, B21D 28/26, B21D 28/06, F21V 29/00, H01L 23/367, F21Y 101/02

(54) **Radiator manufacturing method**
Verfahren zur Herstellung eines Heizkörpers
Procédé de fabrication de radiateurs

(43) Date of publication of application: 20.10.2010
(73) Proprietor: Neng Tyi Precision Industries Co., Ltd., Taipei Hsien (TW)
(72) Inventor: Wei, Wen-Chen, Taipei Hsien (TW)
(74) Representative: Viering, Jentschura & Partner

(56) References cited:
- EP-A1- 2 083 214
- EP-A2- 2 081 220
- EP-A2- 2 086 305
- WO-A1-2010/131828
- CN-Y- 201 159 402
- CN-Y- 201 163 855
- US-A1- 2005 241 360
- US-A1- 2006 054 311

## Description

### BACKGROUND OF THE INVENTION

### 1. Field of the Invention

The present invention relates to a method of manufacturing a radiator, in particular, to a method of manufacturing a radiator that assembles heat dissipation fins on a metal base.

### 2. Description of Related Art

In recent years, Light Emitting Diode (LED) has gradually replaced the traditional light source. Temperatures of the LED module of the LED lamp must be controlled lower than 80 degree Celsius in order to transform the electricity into luminous energy, not thermal energy. That is why the LED lamps have the features of low energy consumption and low heat production. Therefore, the LED lamps are usually equipped with several heat dissipation fins so as to help the LED module quickly dissipating heat. A radiator comprising a metal base and a plurality of heat dissipating fins is known for example from CN 201 159 402 Y.

However, most radiators in the market are mainly categorized into stacked fins and extruded aluminum fins etc. The stacked fins have a plurality of fins connected in series, but the stacked fins can form a ring-shaped body by connecting the first and the last fins, and then be further welded onto a metal base plate to form a radiator; but, after the welding process, the welded joints between the fins and the metal base plate will increase the thermal resistance of the radiator so that it is hard to meet the requirements of the high thermal conductivity. It also requires two phrases refining process, which wastes time and labors, and increases manufacturing cost.

In addition, the extruded aluminum fins are made first by manufacturing a set of extruded aluminum mold; after extruded out, the aluminum is then cut according to the needed fin size; then, the burrs of the fins are removed by a polish process; finally, the appearances of the fins are beautified by a anodizing treatment. The entire procedures are complicated so that the yield is hard to increase, and the overall costs are high.

Accordingly, the present invention is provided, because of the above specified disadvantages of the prior art and based on hands on experience plus academic research and developments, to effectively improve the advantages described above.

### SUMMARY OF THE INVENTION

A main object of the present invention is to provide a method for manufacturing a radiator. The method increases the manufacturing speed, reduces unnecessary assembly processes, largely improves the yield, and decreases the costs, etc.

To achieve the above-mentioned objectives, the present invention provides a method for manufacturing a radiator having a metal base and a plurality of heat dissipation fins. The method comprises a rotating and removing mechanism and preparation, alignment, punching, bending, and shearing and riveting steps. The shearing and riveting and the rotating steps are repeated for a predetermined times.

The preparation step is that placing a metal base on a manufacturing fixture of an aligning-and-moving mechanism of a manufacturing machine having a sheet metal. The metal base has a plurality of slots formed on the periphery of the metal base, and the number of the slots is defined as Y.

The alignment step is that moving the manufacturing fixture and the metal base to a position under the sheet metal by the aligning-and-moving mechanism.

The punching step is first to punch two side-portions of the sheet metal to form a plurality of positioning holes, which the positioning holes are spaced apart by equal distance. A locating pin is then inserted into the located hole. Thereafter, continuously punch the sheet metal to form a plurality of heat dissipation fins on the sheet metal, which the number of the heat dissipation fins is defined as X.

The bending step is to bend the heat dissipation fins downwards.

The shearing and riveting step is that first moving the sheet metal by the manufacturing machine to align one of the heat dissipation fins with one of the slots; then, shearing the heat dissipation fin by a shearing die of the manufacturing machine; the heat dissipation fin is inserted into the slot by the shearing die.

Further, pressing a top surface and a bottom surface of the metal base at two sides of the slot by a riveting blade of the manufacturing machine so as to generate a plastic deformation on the metal base. The deformation causes two side-walls of the slot tightly contacted the two opposite surfaces of the heat dissipation fin.

Furthermore, the rotating step is to rotate the manufacturing fixture so as to rotate the metal base 1/Y round. The shearing and riveting step is repeated for X-1 times, and the rotating step is repeated for Y-1 times. The rest of the heat dissipation fins of the sheet metal are orderly assembled with the Y-1 slots.

After repeating the shearing and riveting step and rotating step, the removing step will be performed. The removing step is to remove the metal base and the heat dissipation fins, after assembly, from the manufacturing fixture. A radiator is achieved.

The efficacy of the present invention is as follows. Via the sheet metal being continuously punched to form the heat dissipation fins in the manufacturing machine, and the heat dissipation fins being orderly inserted into and riveted with the metal base, a radiator can be assembled in an automatic process. The automatic process eliminates the need of a welding process to weld the heat dissipation fins on the metal base, so that thermal resistance problems can be avoided.

The radiator can be manufactured faster, and the unnecessary assembling steps of the radiator can be reduced. Comparing the traditional method for manufacturing the extruded aluminum fins, the method of present invention is simpler and faster, so the yield of the radiator can be improved largely, and the costs of the radiator can be decreased.

In order to further understand the techniques, means and effects the present invention takes for achieving the prescribed objectives, the following detailed descriptions and appended drawings are hereby referred, such that, through which, the purposes, features and aspects of the present invention can be thoroughly and concretely appreciated; however, the appended drawings are merely provided for reference and illustration, without any intention to be used for limiting the present invention.

### BRIEF DESCRIPTION OF THE DRAWINGS

Figure 1 is a flowchart diagram according to a preferred embodiment of the present invention;

Figure 2 is a perspective view showing a radiator according to a preferred embodiment of the present invention;

Figure 3 is a schematic view showing a plurality of metal bases at a metal plate according to a preferred embodiment of the present invention;

Figure 4 is a top view of a metal base after being stamped according to a preferred embodiment of the present invention;

Figure 5 is a top view of a manufacturing machine according to a preferred embodiment of the present invention;

Figure 6 is a side view of the manufacturing machine according to a preferred embodiment of the present invention;

Figure 7 is another side view of the manufacturing machine according to a preferred embodiment of the present invention, which shows a shearing die is moved down;

Figure 8 is a front view of the manufacturing machine according to a preferred embodiment of the present invention, which shows a heat dissipation fin is inserted into the metal base;

Figure 9 is a schematic view showing two riveting blades are aimed to press the metal base according to a preferred embodiment of the present invention; and

Figure 10 is another top view of the manufacturing machine according to a preferred embodiment of the present invention, which shows an assembled radiator is pushed off by the next pending manufacturing fixture.

### DETAILED DESCRIPTION OF THE PREFERRED EMBODIMENTS

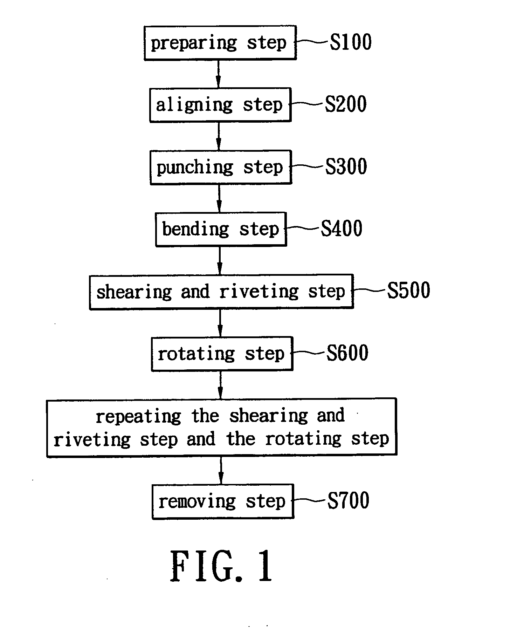

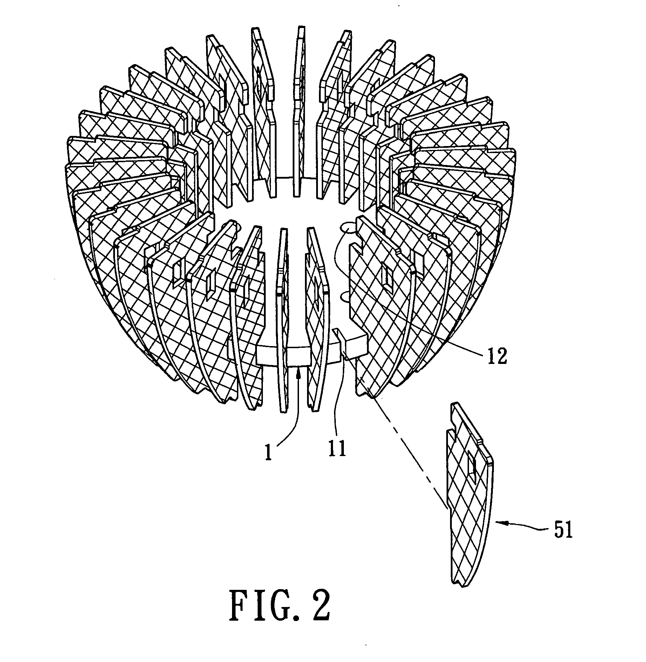

Referring now to Figures 1 and 2, an embodiment of the present invention discloses a method for manufacturing a radiator. The method includes automatically manufacturing a radiator having a metal base 1 and a plurality of heat dissipation fins 51.

Specifically, the method comprises a preparing step (S 100), an aligning step (S200), a punching step (S300), a bending step (S400), a shearing and riveting step (S500), a rotating step (S600), repeating the shearing and riveting step (S500), the rotating step (S600), and a removing step (S700). A number of the heat dissipation fins 51 are defined as X, which the X is a natural number. The metal base 1 is a round plate, and manufactured by a stamping process. The metal base has a plurality of slots 11 and a plurality of positioning holes 12. The slots 11 are formed on the periphery of the metal base 1. A number of the slots 11 is defined as Y, which is corresponding to the number X of the heat dissipation fins 51.

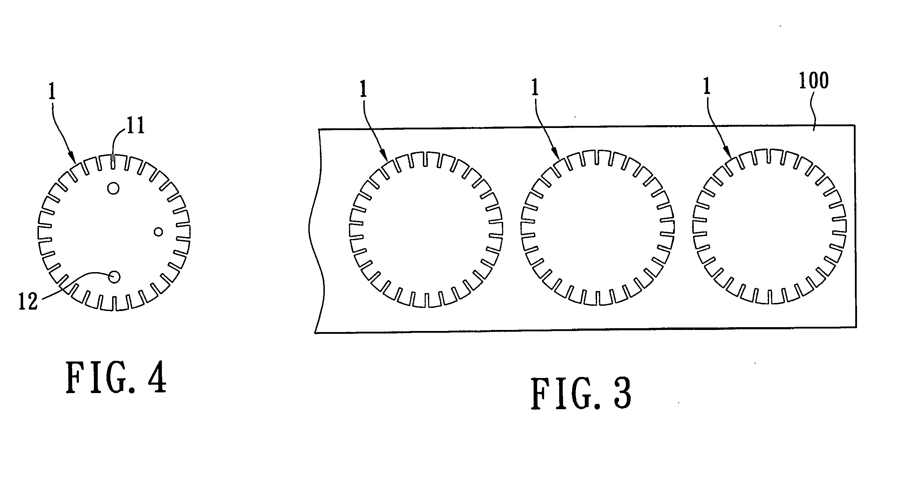

To describe further, please referring to Figures 3 and 4, a metal plate 100 is punched by a stamping process so as to continuously or at the same time one stamping form a plurality of metal bases 1. After the metal plate 100 being punched, the Y slots 11 are also one stamping formed at the periphery of the metal base 1. Using the stamping process forming the metal base 1 possesses, on the one hand, the advantage of fast manufacturing and, on the other hand, the metal base 1 with the positioning holes 12 by stamping.

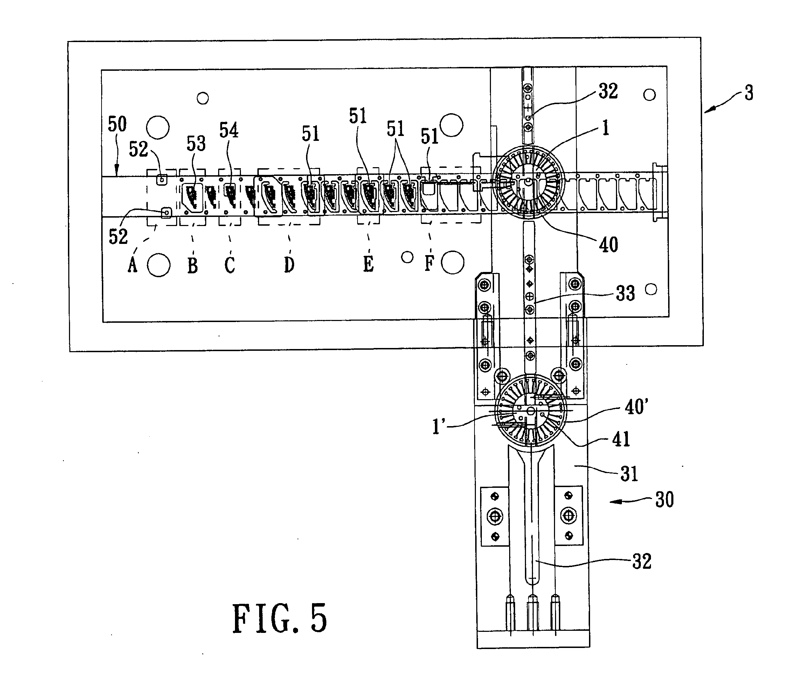

Please referring to Figure 1 and Figure 5, the preparing step (S100) is as follows. The metal base 1 is manually placed on a manufacturing fixture 40 of an aligning-and-moving mechanism 30 of a manufacturing machine 3, which the manufacturing machine 3 has a sheet metal 50. The manufacturing fixture 40 has a plurality of positioning columns 41. The positioning column 41 are inserted into the positioning hole 12 of the metal base 1, so that the metal base 1 is located and fixed at the manufacturing fixture 40.

The aligning-and-moving mechanism 30 comprises a frame 31, a pulling arm 32, and a slide rail assembly 33. The frame 31 is mounted at one end of the manufacturing machine 3. The pulling arm 32 is movably assembled with the frame 31. The slide rail assembly 33 is mounted at the frame 31 and the manufacturing machine 3. A slide chute 42 is provided at the bottom of the manufacturing fixture 40 for engaging with the slide rail assembly 33. The pulling arm 32 is used for pushing the manufacturing fixture 40 sliding on the slide rail assembly 33 to a position under the sheet metal 50.

The aligning step (S200) is as follows. The manufacturing fixture 40 and the metal base 1 are moved to the position under the sheet metal 50 by the aligning-and-moving mechanism 30. To be more specific, the fixture 40 and the metal 1 base are pushed by the pulling arm 32, and then slid on the slide rail assembly 33 to the position under the sheet metal 50.

The punching step (S300) is as follows. Two opposite side-portions of the sheet metal 50 are first punched to form a plurality of positioning holes 52 by a punching mechanism (not shown). The positioning holes 52 are spaced apart by equal distance, as shown at "A" portion of Figure 5. A locating pin (not shown) is inserted into the positioning hole 52, so that the sheet metal 50 can be accurately located and not to be moved. The sheet metal 50 is continuously punched to form the heat dissipation fins 51 by the punching mechanism, as shown at "D" portion of Figure 5.

Among the punching step (S300), after the positioning holes 52 formed, the sheet metal 50 are respectively embossed to form two embossments 53, one of the two embossments 53 is on the top surface of the sheet metal 50, the other one is on the bottom surface of the sheet metal 50, as shown at "B" portion of Figure 5. The embossments 53 increase the heat dissipation area of the heat dissipation fin 51. Then, the sheet metal 50 is punched to form a punched slot 54, as shown at "C" portion of Figure 5. But the punched slot 54 is optional for the heat dissipation fin 51.

Further, the sheet metal 50 is punched to stamp the predetermined shape at one-end of the heat dissipation fin 51, and then stamp the predetermined shape at another end of the heat dissipation fin 51, as shown at "D" portion of Figure 5. In this embodiment, the left end portion of the heat dissipation fin 51 is stamped first; then, stamp the right end portion. However, it is possible to stamp the left end portion of the heat dissipation fin 51 first; then, the left end portion. Finally, the sharp burrs of the heat dissipation fin 51, which are produced via that stamping the predetermined shapes of the heat dissipation fin 51, are removed from the heat dissipation fin 51, as shown in "E" portion of Figure 5.

The bending step (S400) (as shown in "F" portion) is to bend the abovementioned heat dissipation fin 51 downwards, and one end of the heat dissipation fin 51 is still connected to the sheet metal 50.

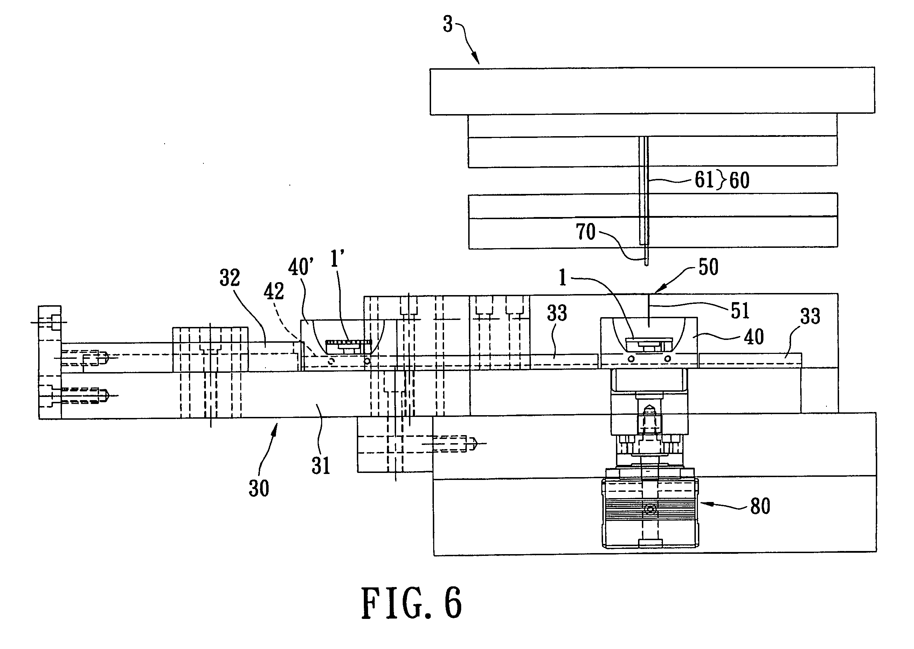

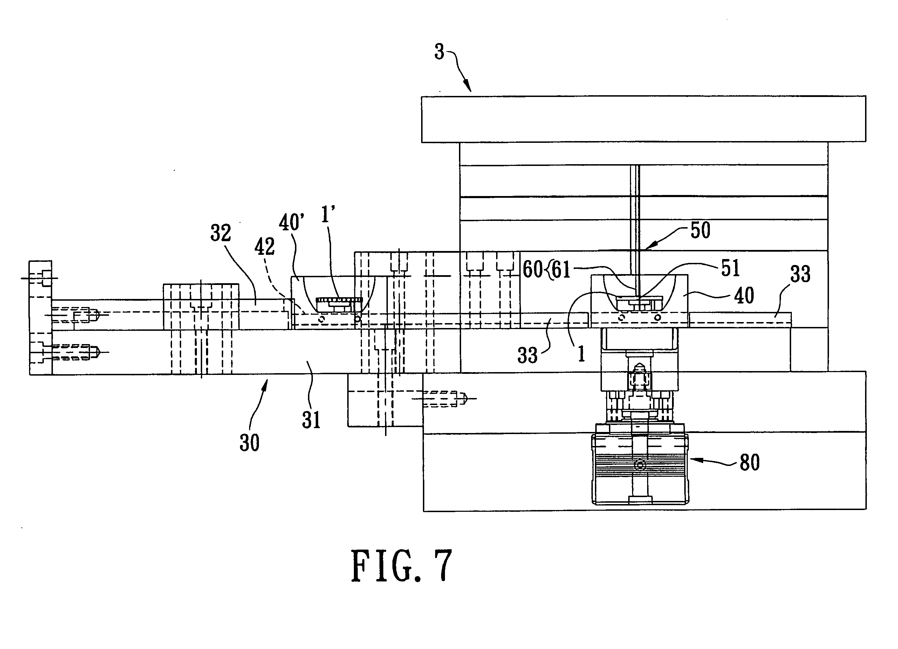

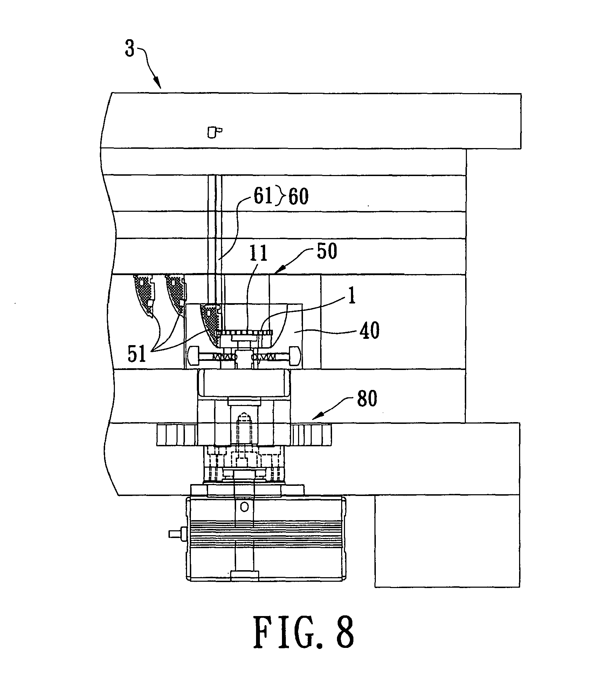

Please referring to Figure 6 to Figure 8, the shearing and riveting step (S500) is as follows. The heat dissipation fins 51 on the sheet metal 50 are moved by the manufacturing machine 3. Hence, one of the heat dissipation fins 51 can be aligned with one of the slots 11. The heat dissipation fin 51 is then sheared and inserted into the slot 11 by a shearing die 60 of the manufacturing machine 3. For further explaining, the shearing die 60 has a vertically movable shearing punch 61 for the uses of shearing the heat dissipation fins 51 of the sheet metal 50, and inserting the heat dissipation fins 51 into the corresponding slots 11 of the metal base 1. The manufacturing fixture 40 is connected with a servo rotating mechanism 80 located under the manufacturing fixture 40. The manufacturing machine 3 has two riveting blades 70.

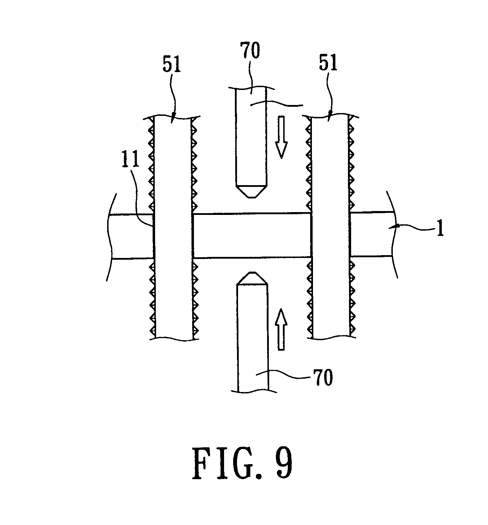

Please referring to Figure 9, the top surface and the bottom surface of the metal base 1 at two sides of the slot 11 are pressed from two directions by the two riveting blades 70 of the manufacturing machine 3 so that a plastic deformation happened to the metal base 1. The plastic deformation causes the two side-walls of the slot 11 tightly contacted the two vertical opposite surfaces of the heat dissipation fin 51 so that the heat dissipation fin 51 can be fixed with the metal base 1.

The rotating step (S600) is performed after the abovementioned steps. The manufacturing fixture 40 is rotated, according to the number Y of the slots 11, 1/Y rounds, then, give order to the next slot 11 to align with the next heat dissipation fin 51 ready to be inserted into the slot 11.

Accordingly, after repeating the above described shearing and riveting step (S500) (X-1) times and the rotating step (S600) (Y-1) times, the heat dissipation fins 51 on the sheet metal 50 can be orderly assembled in the (Y-1) slots 11.

After completing the above described repetitive steps, the removing step (S700) can now be performed. The removing step is to remove the assembled metal base 1 and heat dissipation fins 51 from the manufacturing fixture 40 so as to obtain a radiator.

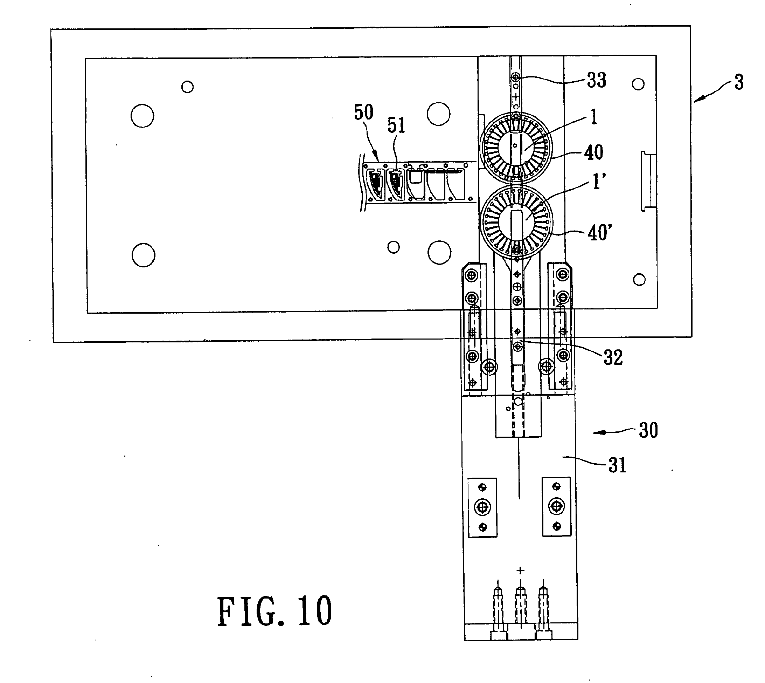

Please refer to Figure 5 and Figure 10. After the aligning step (S200) is done, the next manufacturing fixture 40' and a metal base 1' can now be placed on the aligning-and-moving mechanism 30, during any of the subsequent steps, to form a preparation step. When a radiator is assembled, the aligning step (S200) can be repeated again. The assembled radiator and the manufacturing fixture 40 are pushed off the sheet metal 50 by the ready manufacturing fixture 40'. Thereafter, the removal step (700) and the following steps of the aligning step (S200) can be completed. That is, large quantity of radiators can be manufactured quickly.

Specifically, the metal base 1 is a round plate and the round shape is good for inserting the heat dissipation fins 51 into the slots 11 of the metal base 1 in an orderly and accurate fashion, and also good for the rotating step (S600) to accurately rotate 1/Y times.

Further, the natural number X is preferably greater than ten. If X if smaller than ten, the heat dissipation provided by the heat dissipation fins 51 is less effective. In the present preferred embodiment, there are thirty heat dissipation fins 51 of the radiator. Therefore, the X is equal to 30, and the metal base 1 has thirty slots 11. Accordingly, the heat dissipation fin 51 will be riveted in the slot 11 for thirty times by the manufacturing tool 3.

In the present preferred embodiment, the manufacturing fixture 40 is connected with the servo rotating mechanism 80 located under the manufacturing fixture 40, which causes the metal base 1 to steppingly rotate 1/Y times at each of the Y slot 11.

To sum up the present invention, the present invention has made the sheet metal 50 continuously punched to form the heat dissipation fins 51 in the manufacturing machine 3, and the heat dissipation fins 51 orderly inserted into and riveted with the metal base 1,so that the radiator can be manufactured in an automatic process. Accordingly, there is no need to weld the heat dissipation fins 51 on the metal base 1, which avoids the thermal resistance problems induced by welding processes. Further the radiator can be manufactured faster, and the unnecessary assembling steps of the radiator are reduced. Comparing the traditional method for manufacturing the extruded aluminum fins, the method of present invention is simpler and faster. So the yield of the radiator can be improves largely, and the costs of the radiator are decreased.

## Claims

1. A method for manufacturing a radiator having a metal base (1) and a plurality of heat dissipation fins (51), comprising:
preparing a metal base (1) and placing it on a manufacturing fixture (40) of an aligning-and-moving mechanism (30) of a manufacturing machine (3), wherein the metal base (1) has a plurality of slots (11) at the periphery of the metal base (1), a number of the slots (11) is defined as Y, the manufacturing machine (3) has a sheet metal (50); **characterised by**:
aligning and moving the manufacturing fixture (40) and the metal base (1) to a position under the sheet metal (50);
punching two side-portions of the sheet metal (50) to form a plurality of positioning holes (52), wherein the positioning holes (52) are spaced apart by equal distance, a locating pin is inserted into the positioning hole (52), the sheet metal (50) is continuously punched to form a plurality of heat dissipation fins (51), a number of the heat dissipation fins (51) is defined as X;
bending the heat dissipation fins (51) downwards, wherein one end of the heat dissipation fins (51) is still connected to the sheet metal (50);
shearing and riveting the dissipation fins (51) moved by the manufacturing machine (3), wherein when one of the heat dissipation fins (51) is aligned with one of the slots (11), the heat dissipation fin (51) is sheared and inserted into the slot (11) by a shearing die (60) of the manufacturing machine (3), a top surface and a bottom surface of the metal base (1) at two sides of the slot (11) are pressed by a riveting blade (70) of the manufacturing machine (3) so that a plastic deformation is formed on the metal base (1) and two side-walls of the slot (11) are tightened with two opposite surfaces of the heat dissipation fin (51);
rotating the manufacturing fixture (40), wherein the metal base (1) is rotated 1 /Y circle;
repeating the shearing and riveting for X-1 times, and repeating the rotating for Y-1 times, so that the rest of the heat dissipation fins (51) of the sheet metal (50) are orderly assembled with the Y-1 slots (11); and
removing the metal base (1) and the heat dissipation fins (51) after assembled from the manufacturing fixture (40) to obtain a radiator.

2. The method as claimed in claim 1, wherein the number of the heat dissipation fins (51) is greater than ten.

3. The method as claimed in claim 1, wherein, after the positioning holes (52) are formed at the sheet metal (50), the sheet metal (50) are embossed to form an embossment (53) on the top surface or the bottom surface.

4. The method as claimed in claim 1, wherein, after the heat-dissipation-fins (51) are formed at the sheet metal (50), burrs of the heat dissipation fins (51) are sheared and removed from the heat dissipation fins (51).

5. The method as claimed in claim 1, wherein the manufacturing fixture (40) is connected with a servo rotating mechanism (80) located under the manufacturing fixture (40), and the metal base (1) steppingly rotates 1/Y circle.

6. The method as claimed in claim 1 further comprises preparing a ready manufacturing fixture (40') and a ready metal base (1') after aligning; when the radiator is assembled and the aligning is repeated once, the radiator and the manufacturing fixture (40) are pushed to leave the position under the sheet metal (50) by the ready manufacturing fixture (40').

7. The method as claimed in claim 1, wherein the manufacturing fixture (40) has a positioning column (41) and the metal base (1) has a positioning hole (12); the positioning column (41) is inserted into the positioning hole (12) of the metal base (1) located at the manufacturing fixture (40).

8. The method as claimed in claim 1, wherein the metal base (1) is a round plate.

9. The method as claimed in claim 1, wherein the shearing die (60) has a vertically movable shearing punch (61) for shearing the heat dissipation fins (51) of the sheet metal (50) and for inserting the heat dissipation fins (51) into the corresponding slots (11) of the metal base (1).

## Patentansprüche

1. Ein Verfahren zur Herstellung eines Heizkörpers, welcher einen Metallgrundkörper (1) und eine Vielzahl von Wärmeabführlamellen (51) aufweist, umfassend:
Bereitstellen eines Metallgrundkörpers (1) und Positionieren von diesem an einer Verarbeitungsfixierung (40) eines Justier- und Bewegungs-Mechanismus (30) einer Verarbeitungsmaschine (3), wobei der Metallgrundkörper (1) eine Vielzahl von Schlitzen (11) an dem Umfang des Metallgrundkörpers (1) aufweist, eine Anzahl der Schlitze (11) mit Y definiert ist, und die Verarbeitungsmaschine (3) ein Metallblech (50) aufweist;
**dadurch gekennzeichnet, dass**
die Verarbeitungsfixierung (40) und der Metallgrundkörper (1) zu einer Position unter dem Metallblech (50) justiert und bewegt werden;
zur Ausbildung einer Vielzahl von Positionierungslöchern (52) zwei Seitenabschnitte des Metallblechs (50) gestanzt werden, wobei die Positionierungslöcher (52) in einer gleichbleibenden Entfernung beabstandet voneinander angeordnet sind, ein Führungspin in dem Positionierungsloch (52) eingeführt wird, das Metallblech (50) kontinuierlich gestanzt wird, um eine Vielzahl von Wärmeabführlamellen (51) zu formen, wobei eine Anzahl an Wärmeabführlamellen (51) mit X definiert ist;
die Wärmeabführlamellen (51) nach unten gebogen werden, wobei ein Ende der Wärmeabführlamellen (51) mit dem Metallblech (50) verbunden bleibt;
die Wärmeabführlamellen (51), welche durch die Verarbeitungsmaschine (3) bewegt werden, geschnitten und genietet werden, wobei, wenn eines der Wärmeabführlamellen (51) zu einem der Schlitze (11) justiert wird, die Wärmeabführlamelle (51) geschnitten und mittels eines Schneidwerkzeuges (60) der Verarbeitungsmaschine (3) in den Schlitz (11) eingefügt wird, eine Oberseitenfläche und eine Unterseitenfläche des Metallgrundkörpers (1) an zwei Seiten des Schlitzes (11) mittels eines Nietwerkzeugs (70) der Verarbeitungsmaschine (3) derart gepresst wird, dass eine plastische Deformation an dem Metallgrundkörper (1) ausgebildet wird und zwei Seitenwände des Schlitzes (11) mit zwei gegenüberliegenden Oberflächen der Wärmeabführlamelle (51) fest verbunden werden;
die Verarbeitungsfixierung (40) gedreht wird, wobei der Metallgrundkörper (1) um einen 1/Y Kreis gedreht wird;
das Schneiden und Nieten für X-1 Male wiederholt wird, und das Drehen für Y-1 Male wiederholt wird, so dass der Rest der Wärmeabführlamellen (51) des Metallblechs (50) nach der Reihe in den Y-1 Schlitzen (11) montiert werden; und
der Metallgrundkörper (1) und die Wärmeabführlamellen (51) nach dem Montieren von der Verarbeitungsfixierung (40) entfernt werden, um einen Heizkörper auszubilden.

2. Das Verfahren nach Anspruch 1, wobei die Anzahl der Wärmeabführlamellen (51) größer als zehn ist.

3. Das Verfahren nach Anspruch 1, wobei, nachdem die Positionierungslöcher (52) in dem Metallblech (50) ausgebildet worden sind, das Metallblech (50) von einem Prägewerkzeug (53) an der Oberseitenfläche oder der Unterseitenfläche geprägt wird.

4. Das Verfahren nach Anspruch 1, wobei, nachdem die Wärmeabführlamellen (51) an dem Metallblech (50) ausgebildet worden sind, an den Wärmeabführlamellen (51) ausgebildete Grate abgeschnitten und von den Wärmeabführlamellen (51) entfernt werden.

5. Das Verfahren nach Anspruch 1, wobei die Verarbeitungsfixierung (40) mit einem Servodrehmechanismus (80), der unter der Verarbeitungsfixierung (40) angeordnet ist, verbunden ist, und der Metallgrundkörper (1) schrittweise um einen 1/Y Kreis dreht.

6. Das Verfahren nach Anspruch 1 weiter umfassend: Bereitstellen einer betriebsbereiten Verarbeitungsfixierung (40`) und eines betriebsbereiten Metallgrundkörpers (1') nach dem Justieren; wobei, wenn der Heizkörper montiert wurde und das Justieren einmal wiederholt wurde, der Heizkörper und die Verarbeitungsfixierung (40) mittels der betriebsbereiten Verarbeitungsfixierung (40`) geschoben werden, damit diese die Position unter dem Metallblech (50) verlassen.

7. Das Verfahren nach Anspruch 1, wobei die Verarbeitungsfixierung (40) eine Positionierungssäule (41) und der Metallgrundkörper (1) ein Positionierungsloch (12) aufweisen, wobei die Positionierungssäule (41) in das Positionierungsloch (12) des an der Verarbeitungsfixierung (40) angeordneten Metallgrundkörpers (1) eingeführt wird.

8. Das Verfahren nach Anspruch 1, wobei der Metallgrundkörper (1) eine runde Platte ist.

9. Das Verfahren nach Anspruch 1, wobei das Schneidwerkzeug (60) einen vertikal bewegbaren Schneidstempel (61) zum Schneiden der Wärmeabführlamellen (51) von dem Metallblech (50) und zum Einfügen der Wärmabführlamellen (51) in die entsprechenden Schlitze (11) des Metallgrundkörpers (1) aufweist.

## Revendications

1. Procédé de fabrication d'un radiateur qui présente une base métallique (1) et une pluralité d'ailettes de dissipation de la chaleur (51), comprenant les étapes consistant à :
préparer une base métallique (1) et la placer sur un montage de fabrication (40) d'un mécanisme d'alignement et de déplacement (30) d'une machine de fabrication (3), dans lequel la base métallique (1) présente une pluralité de fentes (11) situées au niveau de la périphérie de la base métallique (1), un certain nombre de fentes (11) étant désignées par Y, la machine de fabrication (3) présentant une tôle (50) ;
**caractérisé par** les étapes consistant à :
aligner et déplacer le montage de fabrication (40) et la base métallique (1) vers une position située sous la tôle (50) ;
poinçonner deux parties latérales de la tôle (50) pour former une pluralité de trous de positionnement (52), lesquels trous de positionnement (52) sont espacés d'une distance égale, une broche de positionnement étant insérée dans le trou de positionnement (52), la tôle (50) étant poinçonnée de manière continue pour former une pluralité d'ailettes de dissipation de la chaleur (51), un certain nombre d'ailettes de dissipation thermique (51) étant désignées par X ;
plier les ailettes de dissipation de la chaleur (51) vers le bas, dans lequel une extrémité des ailettes de dissipation de la chaleur (51) est encore reliée à la tôle (50) ;
cisailler et riveter les ailettes de dissipation (51) déplacées par la machine de fabrication (3), dans lequel, lorsque l'une des ailettes de dissipation de la chaleur (51) est alignée avec l'une des fentes (11), l'ailette de dissipation de la chaleur (51) est cisaillée et insérée dans la fente (11) par un outil à cisailler (60) de la machine de fabrication (3), une surface supérieure et une surface inférieure de la base métallique (1) au niveau des deux côtés de la fente (11) étant pressées par une lame de rivetage (70) de la machine de fabrication (3) de telle sorte qu'une déformation plastique soit formée sur la base métallique (1), et les deux parois latérales de la fente (11) sont serrées avec deux surfaces opposées de l'ailette de dissipation de la chaleur (51) ;
faire tourner le montage de fabrication (40), dans lequel la base métallique (1) est tournée de 1/Y de cercle;
répéter les opérations de cisaillement et de rivetage X-1 fois, et répéter l'opération de rotation Y-1 fois, de telle sorte que le reste des ailettes de dissipation de la chaleur (51) de la tôle (50) soient assemblées de manière ordonnée avec les Y-1 fentes (11) ; et
retirer la base métallique (1) et les ailettes de dissipation de la chaleur (51) une fois assemblées du montage de fabrication (40) afin d'obtenir un radiateur.

2. Procédé selon la revendication 1, dans lequel le nombre d'ailettes de dissipation de la chaleur (51) est supérieur à dix.

3. Procédé selon la revendication 1, dans lequel, une fois que les trous de positionnement (52) sont formés au niveau de la tôle (50), la tôle (50) est estampée pour former un estampage (53) sur la surface supérieure ou sur la surface inférieure.

4. Procédé selon la revendication 1, dans lequel, une fois que les ailettes de dissipation de la chaleur (51) sont formées au niveau de la tôle (50), les bavures des ailettes de dissipation de la chaleur (51) sont cisaillées et éliminées des ailettes de dissipation de la chaleur (51).

5. Procédé selon la revendication 1, dans lequel le montage de fabrication (40) est connecté à un servomécanisme rotatif (80) situé sous le montage de fabrication (40), et la base métallique (1) tourne par pas de 1/Y de cercle.

6. Procédé selon la revendication 1, comprenant en outre une étape consistant à préparer un montage de fabrication prêt (40') et une base métallique prête (1') après l'étape d'alignement ; lorsque le radiateur est assemblé et lorsque l'alignement est répété une fois, le radiateur et le montage de fabrication (40) sont poussés afin de laisser la position sous la tôle (50) par le montage de fabrication prêt (40').

7. Procédé selon la revendication 1, dans lequel le montage de fabrication (40) présente une colonne de positionnement (41) et la base métallique (1) présente un trou de positionnement (12); la colonne de positionnement (41) est insérée dans le trou de positionnement (12) de la base métallique (1) situé au niveau du montage de fabrication (40).

8. Procédé selon la revendication 1, dans lequel la base métallique (1) est une plaque ronde.

9. Procédé selon la revendication 1, dans lequel l'outil à cisailler (60) présente un poinçon de cisaillement (61) mobile verticalement, pour cisailler les ailettes de dissipation de la chaleur (51) de la tôle (50) et insérer les ailettes de dissipation de la chaleur (51) dans les fentes correspondantes (11) de la base métallique (1).
